(19) Europäisches Patentamt
European Patent Office
Office européen des brevets

(11) **EP 4 718 457 A1**

(12) **EUROPEAN PATENT APPLICATION**

(43) Date of publication:
**01.04.2026 Bulletin 2026/14**

(21) Application number: **25197071.1**

(22) Date of filing: **20.08.2025**

(51) International Patent Classification (IPC):
**G11C 11/54** (2006.01)     **G11C 13/00** (2006.01)
**G11C 7/10** (2006.01)

(52) Cooperative Patent Classification (CPC):
**G11C 11/54; G11C 13/003; G11C 13/004;**
**G11C 13/0069;** G11C 7/1006; G11C 13/0004;
**G11C 2213/79; G11C 2213/82**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: **25.09.2024 US 202418896392**

(71) Applicant: **INTEL Corporation**
**Santa Clara, CA 95054 (US)**

(72) Inventors:
- **VOELKER, Moritz**
  **81669 Munich (DE)**
- **BAUMGARTNER, Peter**
  **81929 Munich (DE)**

(74) Representative: **HGF**
**HGF Limited**
**4th Floor, 1 City Square**
**Leeds LS1 2ES (GB)**

(54) **COMPUTE-IN-MEMORY ARRAYS**

(57) Embodiments herein relate to compute-in-memory. In one aspect, memory cells in an array include a larger, primary element and a smaller, secondary element in parallel. The memory cells are phasechange memory (PCM) cells in an example implementation. The second elements are pre-programmed to narrow a conductivity distribution of a column of cells. The pre-programming is based on a measured conductivity distribution of the primary elements of the column. In another aspect, selected memory cells in an array are read using an alternating current (AC) signal which reduces sensing noise. Different bit lines can receive signals with different frequencies and/or amplitudes.

Fig. 7

## Description

### BACKGROUND

Compute-in-memory (CIM) techniques allow calculations to be performed directly in a computer memory, resulting in increased efficiency and reduced power consumption. CIM is particularly beneficial for applications such as high-performance computing and artificial intelligence (AI). However, various challenges are encountered in accurately performing the calculations.

### BRIEF DESCRIPTION OF THE DRAWINGS

The embodiments of the disclosure will be understood more fully from the detailed description given below and from the accompanying drawings of various embodiments of the disclosure, which, however, should not be taken to limit the disclosure to the specific embodiments, but are for explanation and understanding only.

FIG. 1 depicts an example matrix of weights 100 in an analog compute-in-memory (CIM) technique, in accordance with various embodiments.

FIG. 2 depicts example nodes in a neural network 200, consistent with FIG. 1, in accordance with various embodiments.

FIG. 3 depicts an example circuit 300 for CIM, in accordance with various embodiments.

FIG. 4 depicts an example distribution of conductivity for a set of memory cells such as in the circuit 300 of FIG. 3, in accordance with various embodiments.

FIG. 5 depicts an example array of memory cells 500 consistent with FIG. 3, where each memory cell comprises a single large element (LE), in accordance with various embodiments.

FIG. 6 depicts an example distribution of conductance for a set of memory cells consistent with FIG. 5, showing a target level, in accordance with various embodiments.

FIG. 7 depicts an example array of memory cells 700 consistent with FIG. 3, where each memory cell comprises a large element (LE) and a small element (SE), in accordance with various embodiments.

FIG. 8 depicts an example distribution of conductance for a set of memory cells consistent with FIG. 7, where the large elements are programmed to below the target level and the small elements are not programmed, in accordance with various embodiments.

FIG. 9 depicts an example distribution of conductance for a set of memory cells consistent with FIG. 7, where the large element is programmed after the small elements are pre-programmed, in accordance with various embodiments.

FIG. 10 depicts a flowchart of an example process for programming a set of memory cells, in accordance with various embodiments.

FIG. 11 depicts example waveforms used in programming, resetting and reading a set of memory cells, in accordance with various embodiments.

FIG. 12 depicts an example plot of noise versus frequency for a set of memory cells of FIGs. 5 and 7, in accordance with various embodiments.

FIG. 13 depicts an example array of memory cells 1300, where a first alternating-current (AC) signal 1301 is input to a subset of memory cells 1310, in accordance with various embodiments.

FIG. 14A depicts the example array of memory cells 1300 of FIG. 13, where first and second AC signals 1301 and 1302, respectively, having first and second amplitudes, respectively, and a same frequency (f1), are input to a subset of memory cells 1320, in accordance with various embodiments.

FIG. 14B depicts a plot of voltage versus time for the AC signals 1301 and 1302 of FIG. 14A, in accordance with various embodiments.

FIG. 15 depicts the example array of memory cells 1300 of FIG. 13, where first and second alternating-current signals 1301 and 1302, respectively, having first and second amplitudes, respectively, and a same first frequency (f1), and third and fourth alternating-current signals 1303 and 1304, respectively, having the first and second amplitudes, respectively, and a same second frequency (f2), are input to the array of memory cells 1300 of FIG. 13, in accordance with various embodiments.

FIG. 16 depicts an example frequency-selective sense circuit 1600 for use with the array of memory cells 1300 of FIG. 13 or 14, in accordance with various embodiments.

FIG, 17A depicts a plot of PCM cell read current versus time with 1/f noise, and n=10 signals, in accordance with various embodiments.

FIG. 17B depicts a plot of normalized histogram of average current from 50-150 ns over multiple runs, consistent with FIG. 17A, in accordance with various embodiments.

FIG. 18A depicts plots of PCM cell read current versus time with 1/f noise and a sine waveform with a peak-to-peak amplitude of $100\mu A$ and an average of $50\mu A$ (so only positive currents), in accordance with various embodiments.

FIG. 18B depicts plots of PCM cell read current versus time with 1/f noise and a sine waveform with a peak-to-peak amplitude of $100\mu A$ and an average of $0\mu A$ (positive and negative currents), in accordance with various embodiments.

FIG. 19A depicts a plot of a histogram for an average current of $50\mu A$, consistent with FIG. 18A, in accordance with various embodiments.

FIG. 19B depicts a plot of a histogram for an average current of $0\mu A$, consistent with FIG. 18B, in accordance with various embodiments.

FIG. 19C depicts a plot of a histogram for an average current of $25\mu A$, as a modification to FIG. 18A, in accordance with various embodiments.

FIG. 20 illustrates an example of components that may be present in a computing system 2050 for implementing the techniques (e.g., operations, processes, methods, and methodologies) described herein.

DETAILED DESCRIPTION

As mentioned at the outset, various challenges are encountered in performing calculations with compute-in-memory (CIM) techniques.

Analog compute-in-memory (ACIM) applications employ large two-dimensional arrays of memory elements to store a two-dimensional matrix. An example of a desired operation is a vector-matrix multiplication, which is realized by applying input voltages reflecting the input vector elements along the row direction. For each element, the voltages result in an output current which is a product of voltage and the conductivity of the element. The accumulated currents can then be detected along the column direction.

One challenge involves programming. For example, the accuracy with which the matrix elements can be programmed (thereby setting their conductivities) is limited by the physical mechanism of the element programming operation. Typically, the programming results in a distribution of realized conductivities, which limits the accuracy of the results in the vector-matrix multiplication in the reading step.

If the achieved programming level differs too much from the intended level, the programming step can be repeated (by executing a full "erase and program" cycle) in the hope of achieving a better result. However, in CIM applications, typically a full row of memory (representing a vector of data) is programmed in a single step, so while potentially improving the programming of certain elements of the vector, other (accurately programmed) elements are subjected to reprogramming as well, which could result in less accurate programming.

Alternatively, iterative programming can be implemented, where a write-and-verify step is followed by an additional step where special biasing conditions are used to slightly increase the element's conductivity. However, this is more time-consuming and complex.

The solutions provided herein address the above and other challenges. In one aspect, each individual matrix element is realized by two physical elements. A first element (a primary or large element) has a relatively large maximum conductivity. A second element (a secondary or small element) is in parallel with the first element and has a relatively small maximum conductivity.

The secondary element can be pre-programmed by first resetting both the large and small elements to a low conductivity (high resistance) state. Next, the large elements are programmed to a conductivity value slightly below a target value. The actually achieved conductivity of the large element is then measured, and the small elements are programmed based on a difference between target conductivity and achieved conductivity. The pre-programming can occur on a per-column basis in the memory array. Separate control lines can be provided for access transistors for the large and small elements in a column.

In a subsequent vector-matrix multiplication operation, both large and small elements are addressed in parallel, thus adding their conductivities. Due to the smaller programming noise of the small element, the total conductivity, which is the sum of the conductivities of the large and small elements, will be more accurate.

Advantages include increased accuracy of compute-in-memory operations.

Another challenge involves reading. Analog compute-in-memory techniques utilize analog summing of signals (e.g., currents) to perform matrix multiplications very quickly and effectively. This requires an accuracy of several bit (e.g., 4 bits), even in the presence of noise and leakage contributions. However, small memory cells, such as phase change memory (PCM) cells, can exhibit flicker noise or $1/f$ noise contributions which are much higher than thermal noise. This low frequency noise can result in inconsistent results over multiple readouts. Also, leakage currents can require additional select transistors, which increase the area of the memory array.

One possible solution involves using a larger array of larger memory cells since the accuracy per cell is limited. Another possible solution is to use a digital technique but this results in increased current consumption.

The solutions provided herein address the above and other challenges. In one aspect, the memory cells are sensed at one or more defined frequencies. These frequencies can be optimized for low noise of the bit cell (e.g., far from $1/f$ noise) and the sensing circuit (e.g., avoiding crosstalk from the rest of the system). A frequency-selective sensing circuit can sense the memory cells at a specified frequency.

With this alternating-current (AC) sensing at defined frequencies, leakage contributions and other frequency contributions are suppressed, enabling additional simplification of the memory cells.

Advantages include increased accuracy of compute-in-memory operations.

These and other features will be further apparent in view of the following discussion.

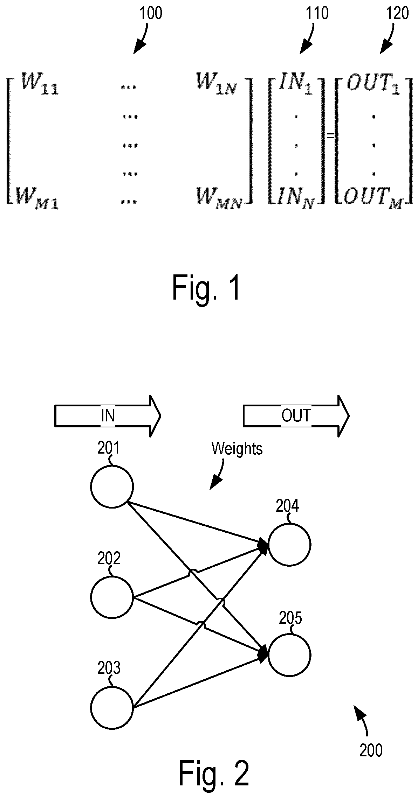

FIG. 1 depicts an example array matrix of weights 100 in an analog compute-in-memory (CIM) technique, in accordance with various embodiments. Analog CIM, also referred to as in-memory-compute, realizes a vector-matrix multiplication by a two-dimensional array of weights, Wij, where i is a row index and j is a column index. The array has M rows and N columns. Vectors 110 and 120 of input and output elements, respectively, are also depicted. The input vector elements, INi, are applied as voltages on the input rows, which for each element results in a current, OUTj, towards the output columns. The currents are the product of input voltage INi and element conductivity Wij (Ohm's law). On each column, the element currents are summed up (Kirchoff's law) and the total current OUTj is detected.

FIG. 2 depicts example nodes in a neural network 200, consistent with FIG. 1, in accordance with various embodiments. Generally, a neural network can be described by layers of nodes, including an input layer, an output layer, and one or more intermediate or hidden layers. This simplified example includes an input layer with nodes 201, 202 and 203 and an output layer with nodes 204 and 205. A node can receive one or more inputs from an external source or other nodes, and compute a corresponding output. Each input has an associated weight which is assigned based on its importance relative to other inputs. The node provides a corresponding output.

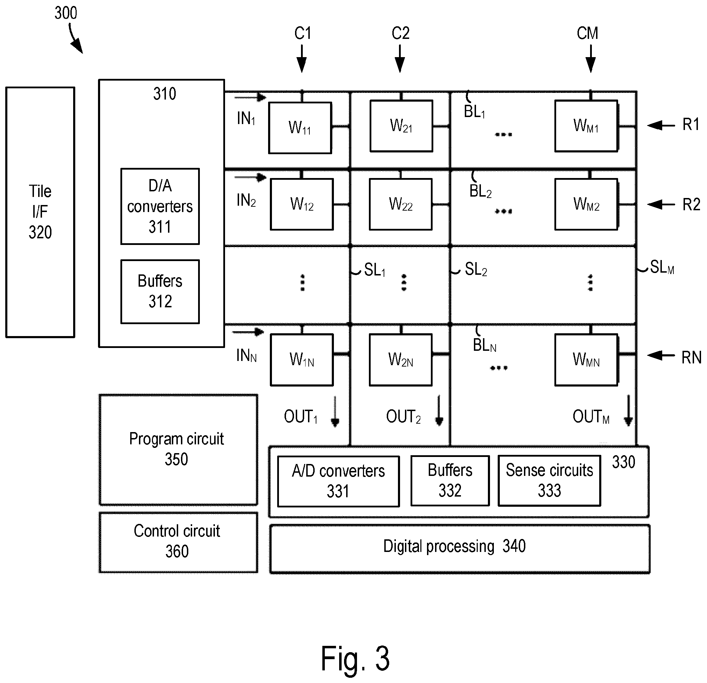

FIG. 3 depicts an example circuit 300 for CIM, in accordance with various embodiments. The circuit performs a desired operation of vector-matrix multiplication. This can be realized by applying voltages reflecting the input vector elements along the row direction and holding the output lines along the columns, e.g., the select lines, to ground (0 V), so for each element there is a current towards the column direction. The current is the product of the input voltage INi and the element conductivity Gij (Ohm's law). On each column j, the sum

$$OUT_j = \sum_{i=1}^{N} IN_i \, W_{ij}$$ of the individual currents (Kirchhoff's law) is detected. The vector comprising the output currents represents the result of the vector-matrix multiplication.

The circuit 300 includes an array of memory cells which are represented by weights Wij. There are N rows and M columns in the array, including rows R0, R1,..., RN, and columns C1, C2,..., CM. In R1, the weights are W11, W21,..., WM1. In R2, the weights are W12, W22,..., WM2. In RN, the weights are W1N, W2N2,..., WMN.

An input voltage INi, where i=1,..., N, is applied to the bit lines BLi from a row driver circuit 310 which includes digital-to-analog (D/A) converters 311 and buffers 312. The input signals are $IN_1$, $IN_2$, ..., $IN_N$ on bit lines $BL_1$, $BL_2$,...,$BL_N$, respectively. A tile interface (I/F) 320 can also be provided. Select lines SLj, where j=1,..., M, are provided to gather the output current of the cells in respective columns of the memory cells. Output currents OUTj are provided to a column circuit 330 which includes analog-to-digital (A/D) converters 331, buffers 332 and sense circuit 333. In particular, output currents are $OUT_1$, $OUT_2$,..., $OUT_M$ on select lines $SL_1$, $SL_2$, ..., $SL_M$, respectively.

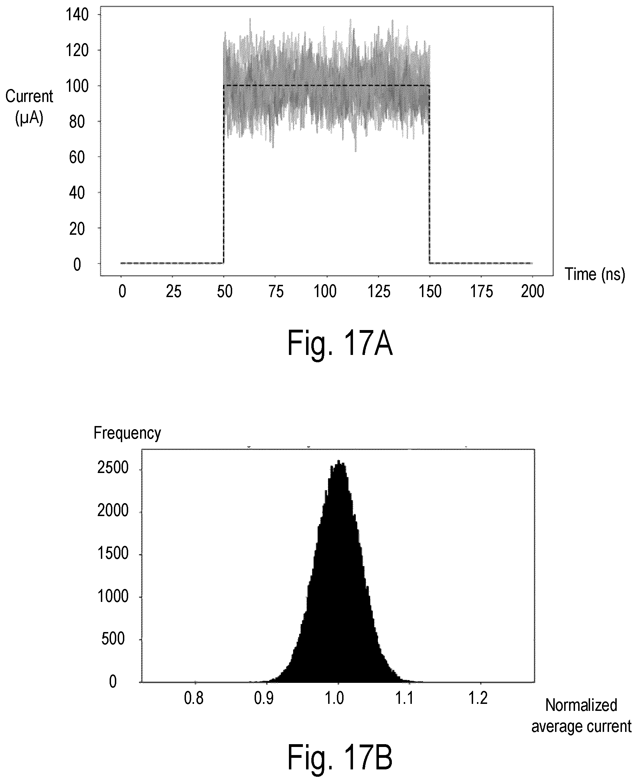

A digital processing circuit 340 receives digital data from the column circuit 330 representing the currents in each column. A program circuit 350 is used to control programming of the memory cells, while a control circuit 360 provides overall control of the circuit including control of read operations. The control circuit 360 and/or program circuit 350 can include a memory capable of storing instructions, and a processor capable of executing the instructions to provide the features described herein. See FIG. 17, for example.

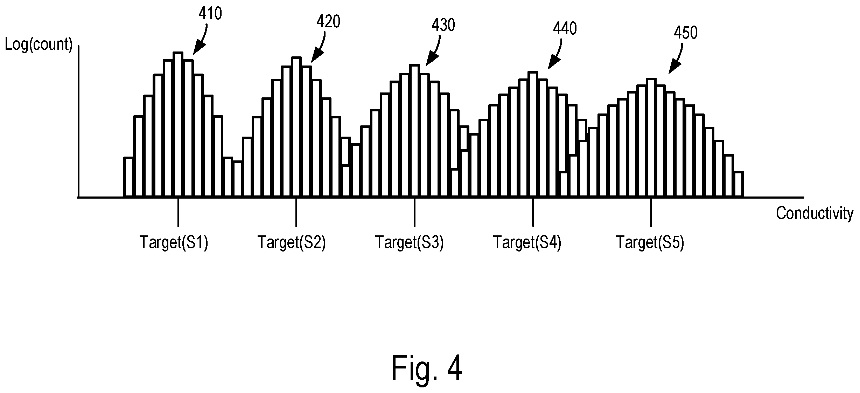

FIG. 4 depicts an example distribution of conductivity for a set of memory cells such as in the circuit 300 of FIG. 3, in accordance with various embodiments. The horizontal axis depicts conductivity (or conductance) and the vertical axis depicts log(count), where count is a number of the memory cells having a given conductivity.

The figure depicts measured conductivities of PCM elements after programming a total of five individual target levels. For each target level, the achieved conductivities are not exactly matching the target level, but fall within a distribution (programming noise). Depending on the width of the distributions, the levels can be overlapping. Each target level can be programming using one-shot programming, where a single program pulse is applied to a memory cell. The program pulse amplitude and/or duration differs for each state.

In particular, the distributions 410, 420, 430, 440 and 450 represent five states S1-S5, respectively, which have a target conductance of Target(S1), Target(S2), Target(S2), Target(S4) and Target(S5), respectively. The distributions can be relatively wide and partly overlapping depending on the physical mechanism underlying the memory elements. Because of the widths od the distributions, the programmed values Wij will not be exact, but fall within a certain distribution. This limits the accuracy at which the desired matrix can be represented.

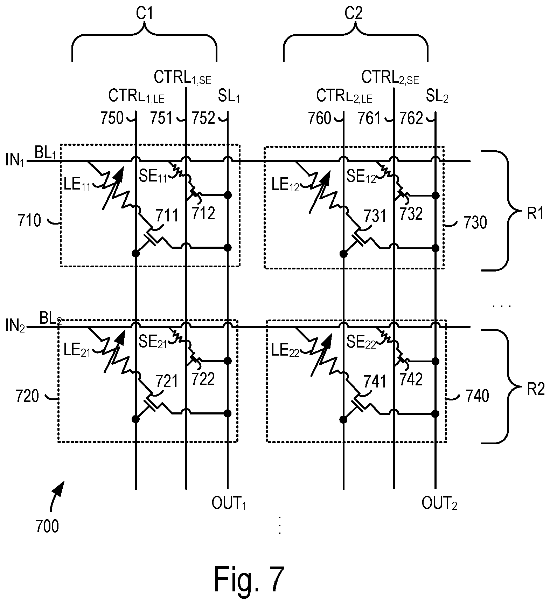

The solutions herein include increasing the representation accuracy by realizing the memory elements as large-plus-small physical elements. See FIG. 7. The small physical elements may be referred to as correction elements. The small elements can be pre-programmed to provide a relatively small conductance which, in combination, with the relatively large conductance of the large element, results in a narrower distribution during a subsequent programming in which data is stored in the cells. An example procedure for the pre-programming includes resetting both large and small elements to low conductivity (high resistance) states. Resetting can involve phase change memory (PCM) cells, but other types of memory can be used as well. For some types of memory, an erase is performed instead of a reset. PCM cells are an example of resistive-switching memory cells.

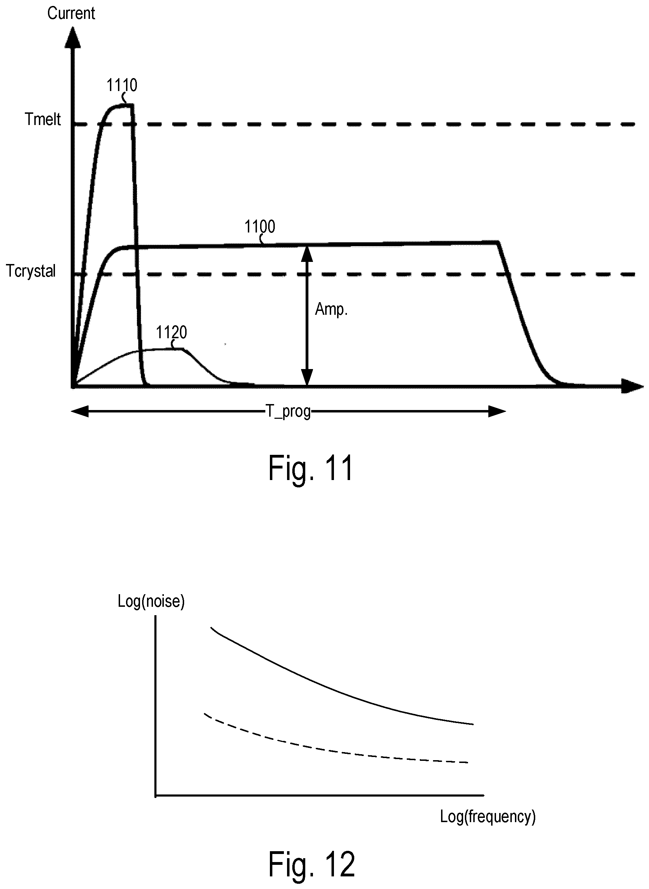

PCM cells are programmed by applying an electrical pulse to change the temperature of the phase change material, which in turn changes the material's physical properties. The material can transition from a crystalline to an amorphous state, or from an amorphous state to a polycrystalline state. The amorphous state has high resistance (logic 0), while the crystalline state has low resistance (logic 1). The switching material can include, e.g., chalcogenide materials such as a Germanium Antimony Tellurium (GST) alloy. Other options include aluminum and antimony. See also FIG. 11.

After the large and small resistive-switching elements are reset, the large elements are programmed to a value slightly below the target value. The sense circuits are then used to measure the actually achieved conductivity of the large elements in a column, for instance. A difference or delta is determined between the target value and the achieved conductivity, and this delta is used to guide a programming of the small elements.

The benefit of this approach is that the variation (programming noise) of the large element can be compensated or corrected by the small element. Although the small element itself introduces programming noise, due to its smaller size, the absolute programming noise of the memory cell will be reduced. The smaller size can be in terms of length, width and/or height, for instance.

Overall, the same target programming level (total conductivity) is achieved, but the variation in conductivity of the memory cell is reduced because the variation is driven mainly by the smaller variation of the small element.

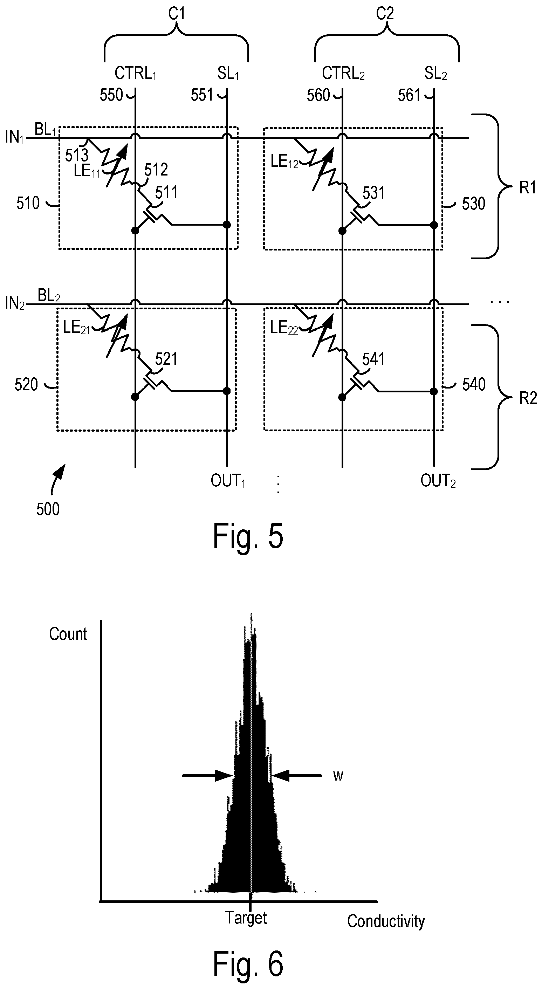

FIG. 5 depicts an example array of memory cells 500 consistent with FIG. 3, where each memory cell comprises a single large element (LE), in accordance with various embodiments. For simplicity, four memory cells in two rows R1 and R2 and two columns C1 and C2 are depicted. An example memory cell 510 includes $LE_{11}$, which is represented by a variable resistor, in series with an access transistor 511, such as an n-type metal-oxide-semiconductor field-effect transistor (MOSFET). As mentioned, the large element can include a PCM material, in an example implementation. Another cell 520 in the same column as the cell 510 includes a large element $LE_{21}$ and an access transistor 521. The second column includes a cell 530 with $LE_{12}$ and an access transistor 531, and a cell 540 with $LE_{22}$ and an access transistor 541.

The access transistors in C1 are coupled at their control gates to a first control line 550 (CTRL,) and at source/drain terminals to a first select line 551 ($SL_1$). Similarly, the access transistors in C2 are coupled at their control gates to a second control line 560 ($CTRL_2$) and at source/drain terminals to a second select line 561 ($SL_2$). The large elements are coupled at one end, e.g., node 512, to a source/drain terminal of the access transistor, e.g., transistor 511, and at an opposing end, e.g., node 513, to a bit line, e.g., $BL_1$.

This comparative approach involves one physical element per matrix element/memory cell.

During programming of cells in a column, the control line is set high to turn on the access transistors to bias the large elements based on the voltages on the respective bit lines. Each memory cell has a single PCM device and a single access transistor, in this implementation. The conductivities Gij of each memory cell are set by applying a programming voltage on the bit lines and turning on (making conductive) the access transistors using the control lines CTRLj. Each column can be programmed separately.

In an example application, the array of memory cells 500 is used for vector-matrix multiplication in analog CIM.

The bit lines and select lines are examples of first and second control lines, respectively. In one approach, the bit lines and select lines extend in orthogonal directions to one another.

FIG. 6 depicts an example distribution of conductance for a set of memory cells consistent with FIG. 5, showing a target level, in accordance with various embodiments. The horizontal axis depicts conductivity and the vertical axis depicts count. The physical mechanism of PCM conductivity change results in a distribution of achieved conductivities, which differ from the targeted conductivity. The delta from the target value is called programming noise. W is an example metric of the width of the distribution such as the full width at half maximum.

FIG. 7 depicts an example array of memory cells 700 consistent with FIG. 3, where each memory cell comprises a large element (LE) and a small element (SE), in accordance with various embodiments. For example, in the first column, the cell 710 includes a large element $LE_{11}$ with a respective access transistor 711 in parallel with a small element $SE_{11}$ and a respective access transistor 712. The large and small elements are both and coupled between $BL_1$ and $SL_1$ (line 752). $SE_{11}$ can be a physically smaller version of $LE_{11}$, for example. Similarly, the cell 720 includes a large element $LE_{21}$ with a respective access transistor 721 in parallel with a small element $SE_{21}$ and a respective access transistor 722.

In the second column, the cell 730 includes a large element $LE_{12}$ with a respective access transistor 731 in parallel with a small element $SE_{12}$ and a respective access transistor 732, and the cell 740 includes a large element $LE_{22}$ with a respective access transistor 741 in parallel with a small element $SE_{22}$ and a respective access transistor 742.

Within a column, the control gates of the access transistors for the large elements are coupled to a first control line, and the control gates of the access transistors for the small elements are coupled to a second control line. For example, in the first column, the control gates of the access transistors 711 and 721 are coupled to a first control line 750 ($CTRL_{1,LE}$), and the control gates of the access transistors 712 and 722 are coupled to a second control line 751 ($CTRL_{1,SE}$). The source/drain terminals of the access transistors of the column are all coupled to a select line of the column, e.g., $SL_1$, in this example implementation.

Similarly, in the second column, the control gates of the access transistors 731 and 741 are coupled to a first control line 760 ($CTRL_{2,LE}$), and the control gates of the access transistors 732 and 742 are coupled to a second control line 761 ($CTRL_{2,SE}$). The source/drain terminals of the access transistors of the column are all coupled to $SL_2$ (line 762).

For conductances in parallel, such as for the LE and SE of a memory cell, the overall conductance is the sum of the individual conductances.

The large and small resistive-switching elements can also be referred to as primary and secondary resistive-switching elements, respectively. The memory cell can be referred to as a dualelement or multiple-element memory cell. The small elements have a variable resistance but the arrow through a resistor notation is not shown for simplicity.

The access transistors for the primary and secondary elements can be referred to as first and second access transistors, respectively.

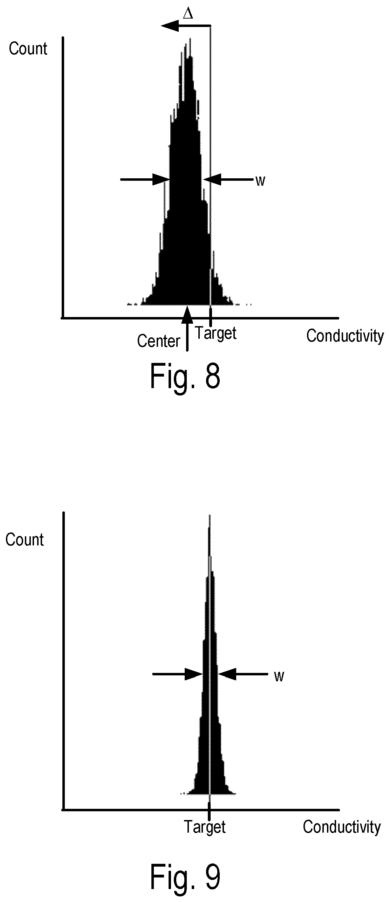

FIG. 8 depicts an example distribution of conductance for a set of memory cells consistent with FIG. 7, where the large elements are programmed to below the target level and the small elements are not programmed, in accordance with various embodiments. In FIGs. 8 and 9, the horizontal axis depicts conductivity and the vertical axis depicts count, and w is an example metric of the width of the distribution such as the full width at half maximum. The value delta ($\Delta$) is measured based on a distance below the target, e.g., a distance between a center of the distribution and the target value.

FIG. 9 depicts an example distribution of conductance for a set of memory cells consistent with FIG. 7, where the large element is programmed after the small elements are pre-programmed, in accordance with various embodiments. The width of the distribution is advantageously narrower than in FIGs. 6 and 8 due to the use of the small element. Additionally, the center of the distribution aligns with the target value. Since the conductivities of the large and small elements are positive values and additive, the programming of the large element aims for a conductivity value slightly below the target value, such that the addition of the conductivity of the small element can result in the final target value.

The variation of the conductivities depends on the physical mechanism underlying the programming of the devices, with PCM a prominent example, but the technique applies to other mechanisms as well. Also, the scaling of the variation with device size (large element vs. small element) can depend on the physical mechanism, but there is an inherent tendency for larger devices to exhibit variations which scale at a rate smaller than the device scaling. In other words, the relative variation of relatively large devices is relatively small.

In the graphs of FIGs, 8 and 9, it is assumed that the absolute variation scales with the square root of the device size. For example, if a device of size 1 has an absolute variation (standard deviation) of 0.1, a device of size 4 would have an absolute variation of 0.2. This "square-root of device size" scaling is found in many device mechanisms where the root cause of the variation is purely statistical.

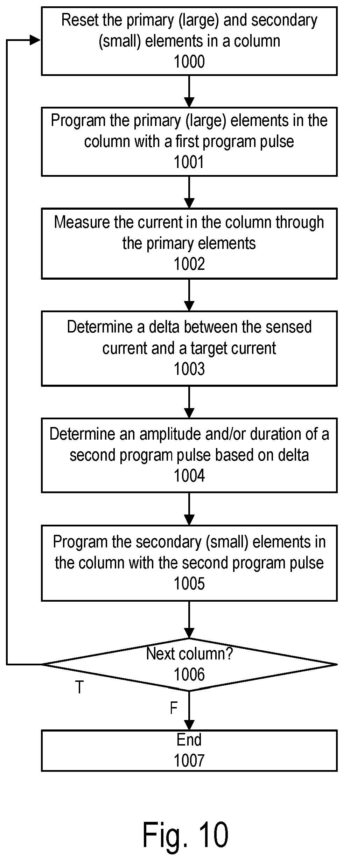

FIG. 10 depicts a flowchart of an example process for programming a set of memory cells, in accordance with various embodiments. Block 1000 includes resetting the primary (large) and secondary (small) elements in a column. Block 1001 includes programming the primary (large) elements in a column with a first program pulse. An example program pulse is depicted in FIG. 11. In this approach, referred to as one-shot programming, a single program pulse is applied to memory cells in a row with a specified amplitude and duration to achieve a desired degree of programming. This approach is fast and efficient as it avoids sensing the cells to determine how much programming has occurred. The secondary elements are disabled from programming at this time by turning off (making non-conductive) their access transistors.

Block 1002 includes measuring the current, e.g., OUTj, in the column through the primary elements. This can include sensing and digitizing the current. The column circuit 330 of FIG. 3 can be used for this purpose. Block 1003 includes determining a delta between the sensed current and a target current. Block 1004 includes determining an amplitude and/or duration of a second program pulse based on the delta. Block 1005 includes programming the secondary (small) elements in the column with the second program pulse. The primary elements are disabled from programming at this time by turning off their access transistors. A decision block 1006 determines whether there is a next column to program. If the decision block is true (T), the flow returns to block 1000. If the decision block is false (F), the process ends at block 1007.

In this approach, the conductivities of the large and small elements are programmed individually. In a first step (block 1000), both elements are reset to their high resistance (low conductivity) states. In a second step (block 1001), the large elements are programmed using the control lines $CTRL_{j,LE}$, with programming levels slightly below the target values of total conductivity. In a third step (blocks 1002 and 1003), the achieved conductivities of the large elements are measured by (for all rows concurrently) applying a reference voltage on the input line $IN_i$, turning on the access transistors of the large elements by the control lines $CTRL_{j,LE}$ and measuring the current OUTj, then calculating the deltas to the target values. In a fourth step (blocks 1004 and 1005), the small elements are programmed to the conductivity deltas calculated in the third step using the control lines $CTRL_{j,SE}$.

The distribution plots of FIGs. 8 and 9 show the programming results for a memory cell after step 2 and step 4, respectively. The vertical lines indicate the targeted value. The programming noise (delta of achieved conductivities to target value) is reduced compared to the single-element approach of FIG. 5.

In the vector-matrix multiplication operation, all control lines are open (conductive) in parallel, so for each matrix element, the conductivities of the large PCM device and the small PCM device add up.

Alternatively, instead of one-shot programming, it is possible to use iterative programming, where a program pulse is applied followed by a verify test. This approach incrementally increases the resistance (and lowers the conductivity) over multiple program-verify cycles. The programming is completed when the conductivity (sensed current) exceeds a specified level.

Another approach involves programming of individual large and small elements, or a row of individual large and small elements. In particular, a selected large element can be programmed such as with a single programming pulse. A sensing operation can then evaluate the conductivity of the large element such as by comparing the sensed current to a number of reference currents which define successive bins or ranges of current. Based on the bin in which the sensed current is classified, a program amplitude and/or duration can be defined for programming the associated small element, e.g., with one-shot programming. This approach can provide even greater accuracy as each small element is customized in its conductivity. In another approach, the small element is programmed using iterative programming to achieve a target conductivity which is based on the conductivity of the large element.

It is also possible to program part (multiple cells) but not all of the cells in a column at the same time.

In one approach, the process is performed under the control of a control circuit which is in the same computing device as the memory array. This allows the programming to occur and be repeated when the device is in the field. In another approach, the process is performed under the control of a control circuit which is external to the memory array. This could occur using external text equipment when the memory array is in the manufacturing/test phase, before being released to the end user.

FIG. 11 depicts example waveforms used in programming, resetting and reading a set of memory cells, in accordance with various embodiments. The horizontal axis denotes time and the vertical axis denotes current. The plot 1100 depicts a programming waveform, which has a duration T_prog and an amplitude Amp. The plot 1110 depicts a reset waveform and the plot 1120 depicts a read waveform.

As mentioned, PCM cells are programmed by applying an electrical pulse to change the temperature of the phase change material, which in turn changes the material's physical properties. During programming, the material transitions from a low resistance, crystalline state to a highresistance (low conductivity), amorphous state when the temperature exceeds a level Tcrystal. During a reset, the material transitions to the low resistance (high conductivity), crystalline state from the highresistance, amorphous state when the temperature exceeds a level Tmelt. The reset pulse has a larger amplitude but a shorter duration compared to the program pulse in this example. The read pulse has a relatively small magnitude so that it does not significantly heat the material.

Conductivity $G=1/R$, where R is resistance. Thus, a high- or low-resistance state of the element will correspond to a low or high conductivity, respectively. The digital processing circuit 340, program circuit 350 and/or control circuit 360 can be configured to determine a program pulse amplitude and/or duration for programming the small elements based on the measured delta. For example, the program pulse amplitude and/or duration can be an increasing function of the delta. That is, when the delta is relatively large, the conductivity of the small element should be relatively large as compensation. The resistance of the small element should there be relatively small, so that the program pulse amplitude and/or duration should be relatively small.

FIGs. 12-16 involve read operations.

FIG. 12 depicts an example plot of noise versus frequency for a set of memory cells of FIGs. 5 and 7, in accordance with various embodiments. The horizontal axis depicts log(frequency) and the vertical axis depicts log(noise). This is a typical noise spectra of PCM memory cells. A pronounced 1/f noise is clearly visible. Noise levels at low frequencies are several orders of magnitude higher than the thermal noise limit. To mitigate the noise contribution, the solutions herein involve sensing at an alternating current (AC) frequency such as in the Mhz range or up to about 1-10 GHz. The dashed line compared to the solid line shows an improvement which can be realized.

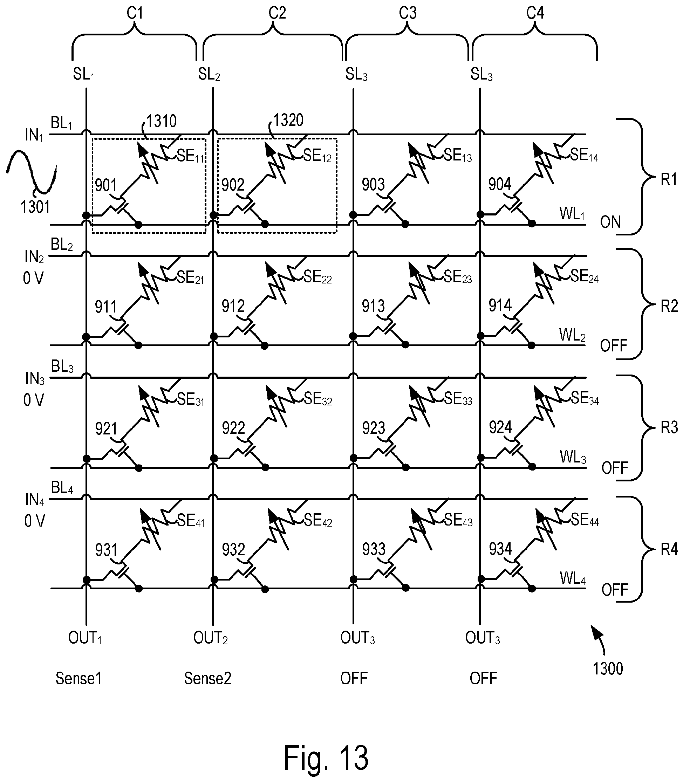

FIG. 13 depicts an example array of memory cells 1300, where a first alternating-current (AC) signal 1301 is input to a subset of memory cells 1310, in accordance with various embodiments. The example array is shown with a single element per memory cell for simplicity, but could be configured with dual elements as discussed previously. The array has a similar format as the array of FIG. 5 except the access transistors are controlled by word lines which extend in the row direction rather than the vertical direction. However, the format of FIG. 5 could be used as well.

In this example, the two memory cells 1310 and 1320 are read using the proposed frequency technique. The word lines (WL) select a single row of cells (R1). Each PCM memory cell has one PCM resistor and one select transistor in this example. The active bit line (BL1) is driven by an AC signal with a defined frequency. This signal can also include a DC offset voltage, which can be used to avoid negative voltages, depending on the circuit and memory cell requirements.

By driving one or more of the bit lines (BL) with an AC voltage at a defined frequency (or multiple frequencies), the resulting sense signal is also a current at this frequency. This AC current is sensed by sense circuits at the sense lines ($SL_1$ and $SL_2$). The sense circuits can use circuitry from wireless communication systems or lock-in amplifiers to detect this narrowband signal. Signals with other frequency components, such as leakage currents, temperature drift or offset induced currents, and noise currents, will be filtered out and advantageously do not contribute to the detected signal.

The memory cells are arranged in columns C1-

C4 and rows R1-R4. A memory cell 1310 includes a storage element $SE_{11}$ in series with an access transistor 901, and coupled between $BL_1$ and $SL_1$. A memory cell 1320 includes a storage element $SE_{12}$ in series with an access transistor 902, and coupled between $BL_1$ and $SL_2$. The other memory cells can be configured similarly. For example, the memory cell in R1, C3 includes $SE_{13}$ and transistor 903, and the memory cell in R1, C4 includes $SE_{14}$ and transistor 904. In R2, the memory cell in C1 includes $SE_{21}$ and transistor 911, the memory cell in C2 includes $SE_{22}$ and transistor 912, the memory cell in C3 includes $SE_{23}$ and transistor 913, and the memory cell in C4 includes $SE_{24}$ and transistor 914.

In R3, the memory cell in C1 includes $SE_{31}$ and transistor 921, the memory cell in C2 includes $SE_{32}$ and transistor 922, the memory cell in C3 includes $SE_{33}$ and transistor 923, and the memory cell in C4 includes $SE_{34}$ and transistor 924. In R4, the memory cell in C1 includes $SE_{41}$ and transistor 931, the memory cell in C2 includes $SE_{42}$ and transistor 932, the memory cell in C3 includes $SE_{43}$ and transistor 933, and the memory cell in C4 includes $SE_{44}$ and transistor 934.

In this example, the memory cells 1310 and 1320 are selected by setting WL1 on, or high, to turn on the access transistors 901 and 902. The other word lines, WL2-WL4 are kept off, or low (e.g., 0 V). An AC signal 1301 is applied as $IN_1$ to $BL_1$, to provide a corresponding AC bias across the memory elements 1310 and 1320, and their storage elements $SE_{11}$ and $SE_{12}$, respectively.

The output currents $OUT_1$ and $OUT_2$ on $SL_1$ and $SL_2$, respectively, are sensed as sense values Sense1 and Sense2, respectively. The sensing is turned off for C3 and C4. A ground voltage, 0 V, can be applied to $BL_2$-$BL_4$ so that the associated cells are not programmed.

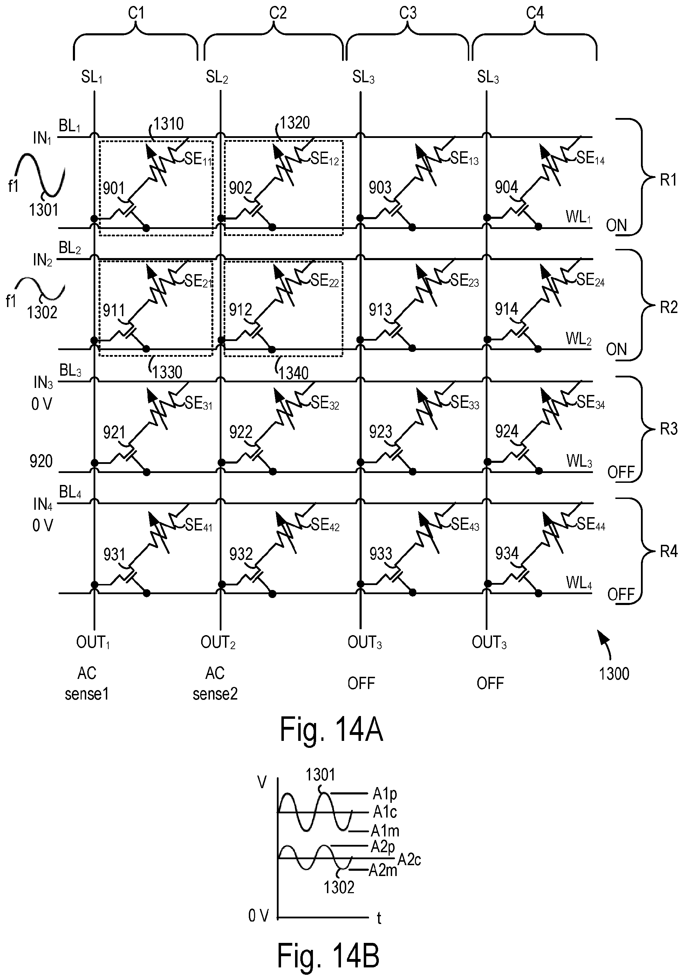

FIG. 14A depicts the example array of memory cells 1300 of FIG. 13, where first and second AC signals 1301 and 1302, respectively, having first and second amplitudes, respectively, and a same frequency (f1), are input to a subset of memory cells 1320, in accordance with various embodiments.

A significant benefit of this technique involves analog matrix multiplication, where the signals from the bit cells are summed along the sense line, with different weights on each row. This is demonstrated in FIG. 14A. The multiplication weights are implemented as the amplitude of the AC bit line signal. In this example, two bit lines are used, and the corresponding word lines are switched on. The analog matrix multiplication is of a 2x2 block inside a 4x4 matrix, in this example. The cells 1310, 1320, 1330 and 1340 are used for active vector matrix multiplication while the remaining cells are inactive. Larger arrays, matrices, and vectors can be used in practice. The inactive PCM cells connected to the active sense lines are not driven by AC signals, effectively suppressing their leakage contribution.

In particular, the memory cells 1310, 1320, 1330 and 1340 are selected by setting WL1 and WL2 on, or high, to turn on the access transistors 901, 902, 911 and 912. The other word lines, WL3 and WL4 are kept off.

The first AC signal 1301 is applied as $IN_1$ to $BL_1$, to provide a corresponding AC bias across the memory elements 1310 and 1320, and their storage elements $SE_{11}$ and $SE_{12}$, respectively, as in FIG. 13. Additionally, a second AC signal 1302 is applied as $IN_2$ to $BL_2$, to provide a corresponding AC bias across the memory elements 1330 and 1340, and their storage elements $SE_{21}$ and $SE_{22}$, respectively. The output currents $OUT_1$ and $OUT_2$ on $SL_1$ and $SL_2$, respectively, are sensed as sense values AC sense1 and AC sense2, respectively. The sensing is turned off for C3 and C4.

The first AC signal can have a larger amplitude than the second AC signal, for example.

A ground voltage, 0 V, can be applied to $BL_3$ and $BL_4$ so that the associated cells are not programmed.

FIG. 14B depicts a plot of voltage versus time for the AC signals 1301 and 1302 of FIG. 14A, in accordance with various embodiments. The AC signals can be sinusoidal as shown, or have another periodic shape such as a square or triangular wave, for instance. The AC signal 1301 ranges between a minimum A1m and a maximum or peak A1p, where a central value, e.g., an average, is A1c. The AC signal 1302 ranges between a minimum A2m and a maximum or peak A2p, where a central value is A2c. The range of the signals can be the same or different. The AC signals can be fully positive, or range between positive and negative voltages, but should avoid being so low that there is a risk of inadvertently turning on access transistors. To mitigate this risk, negative word line voltages can be used on the gates of the transistors and the negative voltages can be limited to, e.g., <0.5V range. The average amplitude can correspond to a multiplication weight, as discussed above, in one possible approach. See also FIGs. 17A-19C.

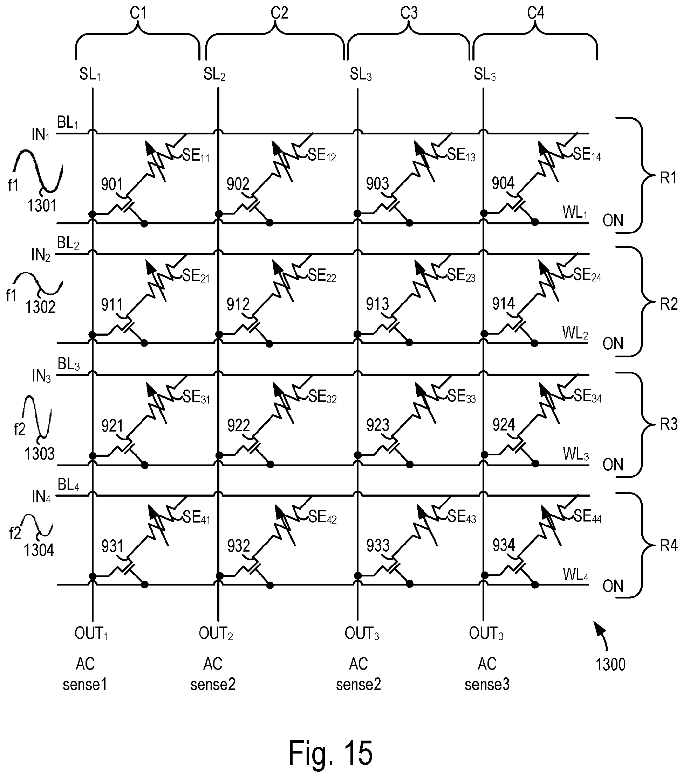

FIG. 15 depicts the example array of memory cells 1300 of FIG. 13, where first and second alternating-current signals 1301 and 1302, respectively, having first and second amplitudes, respectively, and a same first frequency (f1), and third and fourth alternating-current signals 1303 and 1304, respectively, having the first and second amplitudes, respectively, and a same second frequency (f2), are input to the array of memory cells 1300 of FIG. 13, in accordance with various embodiments.

This frequency-selective sensing can be further enhanced to enable parallel analog matrix multiplications by utilizing multiple frequencies, as shown in FIG. 15. In this example, four 2x2 matrix multiplications can be performed in parallel using two frequencies (f1, f2). The output vectors are distributed over the different sense lines and frequencies as follows:

    A: Vector OutA = Sense1@f1 / Sense2@f1
    B: Vector OutB = Sense1@f2 / Sense2@f2
    C: Vector OutC = Sense3@f1 / Sense4@f1

D: Vector OutD = Sense3@f2 / Sense4@f2

This example can be extended to larger vectors and matrices. Moreover, the use of additional frequencies can further increase parallelization, albeit at the cost of increased circuit complexity.

In particular, the WLs are all turned on in this example so that all cells are selected for programming. The first AC signal 1301 is applied as $IN_1$ to $BL_1$, to provide a corresponding AC bias across each of the memory elements of R0 and their storage elements. The second AC signal 1302 is applied as $IN_2$ to $BL_2$, to provide a corresponding AC bias across each of the memory elements of R1 and their storage elements. A third AC signal 1303 is applied as $IN_3$ to $BL_3$, to provide a corresponding AC bias across each of the memory elements of R3 and their storage elements. A fourth AC signal 1304 is applied as $IN_4$ to $BL_4$, to provide a corresponding AC bias across each of the memory elements of R4 and their storage elements.

The output currents $OUT_1$, $OUT_2$, $OUT_3$, and $OUT_4$ on $SL_1$, $SL_2$, $SL_3$ and $SL_4$, respectively, are sensed as sense values AC sense1, AC sense2, AC sense3, and AC sense4, respectively.

Another benefit of the technique could be the use of a smaller memory cell, as it allows for memory cells without select transistors, which are much smaller than memory cells with select transistors. Example of memory cells without select transistors include dynamic random-access memory (DRAM), NOR flash, 2D or 3D NAND flash (single-level or multi-level) and PCM (single-level or multi-level with an access n-type FET). Examples of memory cells with select transistors include static random-access memory (SRAM). For example, the memory cells could be floating-gate MOSFETs (flash memory cells).

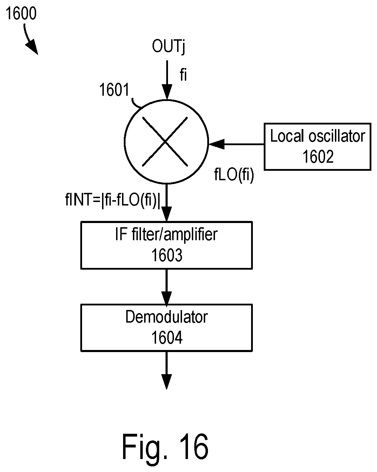

FIG. 16 depicts an example frequency-selective sense circuit 1600 for use with the array of memory cells 1300 of FIG. 13 or 14, in accordance with various embodiments. The sense circuit includes a mixer 1601 which mixes the signal OUTj having a frequency fi with a signal having a frequency fLO(fi) from a local oscillator 1602. The output of the mixer has an intermediate frequency fINT=|f1-fLO(fi)|. fLO(fi) is set as a function of the frequency which is to be tuned, e.g., fi, so that fINT is a constant regardless of fi. For example, consider the first and second frequencies, f1 and f2, respectively, of FIG. 15. To tune to f1, fLO(f1) is set as f1-fINT if f1>fINT or f1+fINT if f1<fINT. To tune to f2, fLO(f2) is set as f2-fINT if f2>fINT or f2+fINT if f2<fINT.

The IF filter/amplifier 1603 includes a band-pass filter that operates at a fixed frequency to amplify and filter the input signal. The IF filter can be part of an IF amplifier, which is a high-gain, single-frequency tuned radio frequency amplifier. The output of the IF filter/amplifier 1603 is received at a demodulator 1604, which obtain a direct current (DC) value from the signal. The value, representing a current, can then be sensed.

The sense circuit 1600 is therefore frequency-selective so that it can sense current which results from a periodic voltage at a specified frequency. For example, in FIG. 15, a first sense circuit can sense AC sense1 by tuning to f1 while a second sense circuit can concurrently sense AC sense2 by tuning to f2.

FIG, 17A depicts a plot of PCM cell read current versus time with 1/f noise, and n=10 signals, in accordance with various embodiments. This is for a comparative read process. The signal is applied for a period of 100ns to obtain the read current, which is superimposed with flicker noise. The noise power scales with I^2 of the read current. This plot depicts ten runs with noise. The values are just chosen to visualize the effects, not based on real devices. During reading of the cell, averaged signal of this fluctuating current is obtained.

FIG. 17B depicts a plot of normalized histogram of average current from 50-150 ns over multiple runs, consistent with FIG. 17A, in accordance with various embodiments.

As mentioned, the reading can use an AC signal with different amplitudes, and DC offsets and a waveform shapes.

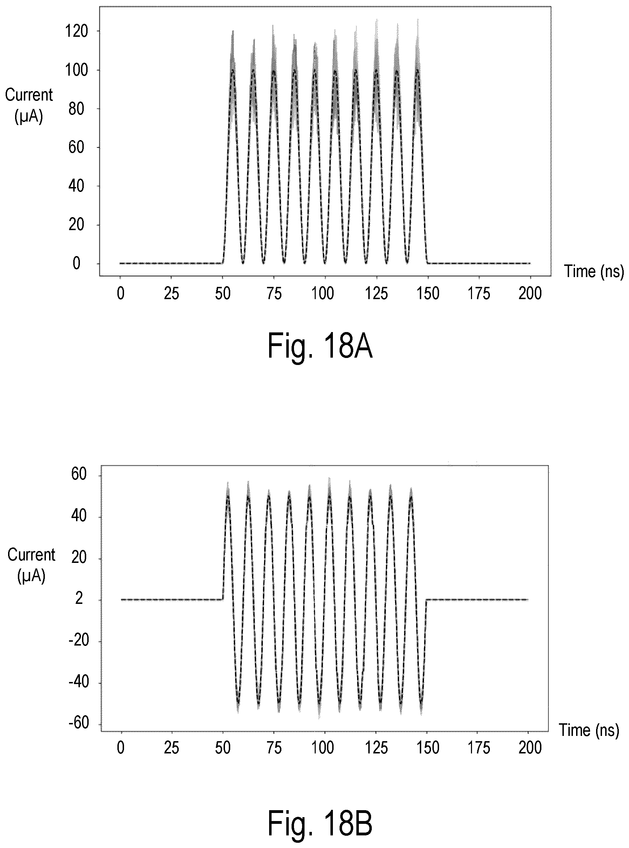

FIG. 18A depicts plots of PCM cell read current versus time with 1/f noise and a sine waveform with a peak-to-peak amplitude of $100\mu A$ and an average of $50\mu A$ (so only positive currents), in accordance with various embodiments. The frequency is 100MHz and there is a 100ns window (so 10 cycles in the window).

FIG. 18B depicts plots of PCM cell read current versus time with 1/f noise and a sine waveform with a peak-to-peak amplitude of $100\mu A$ and an average of $0\mu A$ (positive and negative currents), in accordance with various embodiments.

To read this signal, a coherent detection or demodulation can be used in which the read current is multiplied by with a sine signal of same phase and the result is averaged.

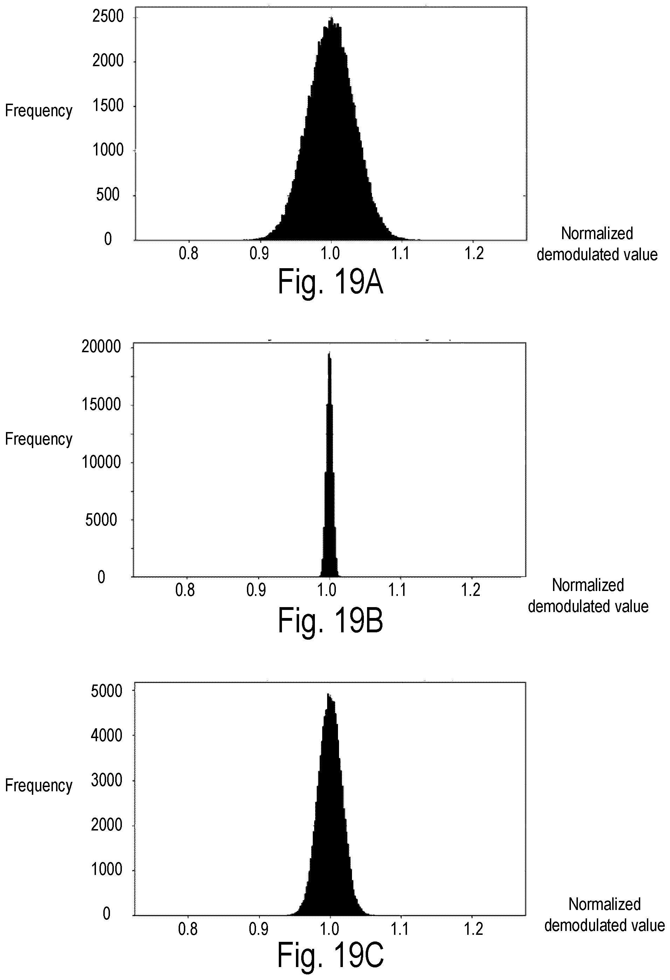

FIG. 19A depicts a plot of a histogram for an average current of $50\mu A$, consistent with FIG. 18A, in accordance with various embodiments.

FIG. 19B depicts a plot of a histogram for an average current of $0\mu A$, consistent with FIG. 18B, in accordance with various embodiments.

FIG. 19C depicts a plot of a histogram for an average current of $25\mu A$, as a modification to FIG. 18A, in accordance with various embodiments.

The histograms depict frequency versus normalized demodulated value. The horizontal axis has the same scale on all three histograms. Generally, a much narrower distribution is obtained with lower average currents. This advantage is a result of the noise suppression.

Accordingly, performance can be improved by using negative currents and voltages to drive the cell. However, the current or voltage should not be so low that it turns on the access transistors of unselected cells.

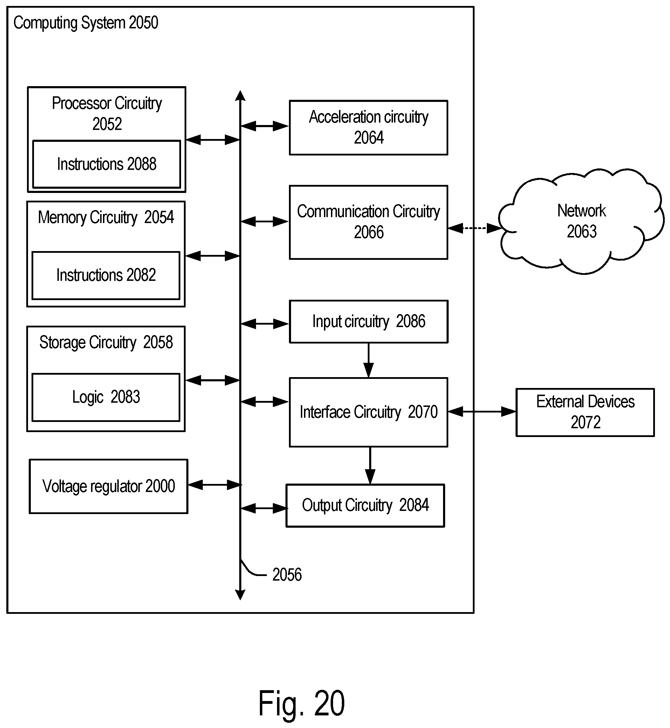

FIG. 20 illustrates an example of components that may be present in a computing system 2050 for implementing the techniques (e.g., operations, processes, methods, and methodologies) described herein.

The computing system 2050 may include any combinations of the hardware or logical components referenced herein. The components may be implemented as ICs, portions thereof, discrete electronic devices, or other modules, instruction sets, programmable logic or algorithms, hardware, hardware accelerators, software, firmware, or a combination thereof adapted in the computing system 2050, or as components otherwise incorporated within a chassis of a larger system. In an example implementation, the memory arrays described herein can be provided, e.g., in the memory circuitry 2054 or storage circuitry 2058, for example. The associated circuitry such as for providing voltages to the memory array and sensing current from the array can be provided, e.g., in the memory circuitry itself and/or the processor circuitry 2052, for example.

In one approach, all or part of the computing system 2050 is provided in a SoP, System in Package (SiP) or a System on Chip (SoC).

The voltage regulator can provide a voltage Vout to one or more of the components of the computing system 2050. The memory circuitry 2054 may store instructions and the processor circuitry 2052 may execute the instructions to perform the functions described herein.

The system 2050 includes processor circuitry in the form of one or more processors 2052. The processor circuitry 2052 includes circuitry such as, but not limited to one or more processor cores and one or more of cache memory, low drop-out voltage regulators (LDOs), interrupt controllers, serial interfaces such as SPI, I2C or universal programmable serial interface circuit, real time clock (RTC), timer-counters including interval and watchdog timers, general purpose I/O, memory card controllers such as secure digital/multi-media card (SD/MMC) or similar, interfaces, mobile industry processor interface (MIPI) interfaces and Joint Test Access Group (JTAG) test access ports. In some implementations, the processor circuitry 2052 may include one or more hardware accelerators (e.g., same or similar to acceleration circuitry 2064), which may be microprocessors, programmable processing devices (e.g., FPGA, ASIC, etc.), or the like. The one or more accelerators may include, for example, computer vision and/or deep learning accelerators. In some implementations, the processor circuitry 2052 may include on-chip memory circuitry, which may include any suitable volatile and/or non-volatile memory, such as DRAM, SRAM, EPROM, EEPROM, Flash memory, solid-state memory, and/or any other type of memory device technology, such as those discussed herein

The processor circuitry 2052 may include, for example, one or more processor cores (CPUs), application processors, GPUs, RISC processors, Acorn RISC Machine (ARM) processors, CISC processors, one or more DSPs, one or more FPGAs, one or more PLDs, one or more ASICs, one or more baseband processors, one or more radio-frequency integrated circuits (RFIC), one or more microprocessors or controllers, a multi-core processor, a multithreaded processor, an ultra-low-voltage processor, an embedded processor, or any other known processing elements, or any suitable combination thereof. The processors (or cores) 2052 may be coupled with or may include memory/storage and may be configured to execute instructions stored in the memory/storage to enable various applications or operating systems to run on the platform 2050. The processors (or cores) 2052 is configured to operate application software to provide a specific service to a user of the platform 2050. In some embodiments, the processor(s) 2052 may be a special-purpose processor(s)/controller(s) configured (or configurable) to operate according to the various embodiments herein.

As examples, the processor(s) 2052 may include an Intel® Architecture Core™ based processor such as an i3, an i5, an i7, an i9 based processor; an Intel® microcontroller-based processor such as a Quark™, an Atom™, or other MCU-based processor; Pentium® processor(s), Xeon® processor(s), or another such processor available from Intel® Corporation, Santa Clara, California. However, any number other processors may be used, such as one or more of Advanced Micro Devices (AMD) Zen® Architecture such as Ryzen® or EPYC® processor(s), Accelerated Processing Units (APUs), MxGPUs, Epyc® processor(s), or the like; A5-A12 and/or S1-S4 processor(s) from Apple® Inc., Snapdragon™ or Centriq™ processor(s) from Qualcomm® Technologies, Inc., Texas Instruments, Inc.® Open Multimedia Applications Platform (OMAP)™ processor(s); a MIPS-based design from MIPS Technologies, Inc. such as MIPS Warrior M-class, Warrior I-class, and Warrior P-class processors; an ARM-based design licensed from ARM Holdings, Ltd., such as the ARM Cortex-A, Cortex-R, and Cortex-M family of processors; the ThunderX2® provided by Cavium™, Inc.; or the like. In some implementations, the processor(s) 2052 may be a part of a system on a chip (SoC), System-in-Package (SiP), a multi-chip package (MCP), and/or the like, in which the processor(s) 2052 and other components are formed into a single integrated circuit, or a single package, such as the Edison™ or Galileo™ SoC boards from Intel® Corporation. Other examples of the processor(s) 2052 are mentioned elsewhere in the present disclosure.

The system 2050 may include or be coupled to acceleration circuitry 2064, which may be embodied by one or more AI/ML accelerators, a neural compute stick, neuromorphic hardware, an FPGA, an arrangement of GPUs, one or more SoCs (including programmable SoCs), one or more CPUs, one or more digital signal processors, dedicated ASICs (including programmable ASICs), PLDs such as complex (CPLDs) or high complexity PLDs (HCPLDs), and/or other forms of specialized processors or circuitry designed to accomplish one or more specialized tasks. These tasks may include AI/ML processing (e.g., including training, inferencing, and classification operations), visual data processing, network data processing, object detection, rule analysis, or the like. In FPGA-based implementations, the acceleration circuitry 2064 may comprise logic blocks or logic fabric and other interconnected resources that may be programmed (configured) to perform various functions, such as the procedures, methods, functions, etc. of the various embodiments discussed herein. In such implementations, the acceleration circuitry 2064 may also include memory cells (e.g., EPROM, EEPROM, flash memory, static memory (e.g., SRAM, anti-fuses, etc.) used to store logic blocks, logic fabric, data, etc. in LUTs and the like.

In some implementations, the processor circuitry 2052 and/or acceleration circuitry 2064 may include hardware elements specifically tailored for machine learning and/or artificial intelligence (AI) functionality. In these implementations, the processor circuitry 2052 and/or acceleration circuitry 2064 may be, or may include, an AI engine chip that can run many different kinds of AI instruction sets once loaded with the appropriate weightings and training code. Additionally or alternatively, the processor circuitry 2052 and/or acceleration circuitry 2064 may be, or may include, AI accelerator(s), which may be one or more of the aforementioned hardware accelerators designed for hardware acceleration of AI applications. As examples, these processor(s) or accelerators may be a cluster of artificial intelligence (AI) GPUs, tensor processing units (TPUs) developed by Google® Inc., Real AI Processors (RAPs™) provided by AlphaICs®, Nervana™ Neural Network Processors (NNPs) provided by Intel® Corp., Intel® Movidius™ Myriad™ X Vision Processing Unit (VPU), NVIDIA® PX™ based GPUs, the NM500 chip provided by General Vision®, Hardware 3 provided by Tesla®, Inc., an Epiphany™ based processor provided by Adapteva®, or the like. In some embodiments, the processor circuitry 2052 and/or acceleration circuitry 2064 and/or hardware accelerator circuitry may be implemented as AI accelerating co-processor(s), such as the Hexagon 685 DSP provided by Qualcomm®, the PowerVR 2NX Neural Net Accelerator (NNA) provided by Imagination Technologies Limited®, the Neural Engine core within the Apple® A11 or A12 Bionic SoC, the Neural Processing Unit (NPU) within the HiSilicon Kirin provided by Huawei®, and/or the like. In some hardware-based implementations, individual subsystems of system 2050 may be operated by the respective AI accelerating co-processor(s), AI GPUs, TPUs, or hardware accelerators (e.g., FPGAs, ASICs, DSPs, SoCs, etc.), etc., that are configured with appropriate logic blocks, bit stream(s), etc. to perform their respective functions.

The system 2050 also includes system memory 2054. Any number of memory devices may be used to provide for a given amount of system memory. As examples, the memory 2054 may be, or include, volatile memory such as random access memory (RAM), static RAM (SRAM), dynamic RAM (DRAM), synchronous DRAM (SDRAM), RAMBUS® Dynamic Random Access Memory (RDRAM®), and/or any other desired type of volatile memory device. Additionally or alternatively, the memory 2054 may be, or include, non-volatile memory such as read-only memory (ROM), erasable programmable ROM (EPROM), electrically erasable programmable (EEPROM), flash memory, non-volatile RAM, ferroelectric RAM, phase-change memory (PCM), flash memory, and/or any other desired type of non-volatile memory device. Access to the memory 2054 is controlled by a memory controller. The individual memory devices may be of any number of different package types such as single die package (SDP), dual die package (DDP) or quad die package (Q17P). Any number of other memory implementations may be used, such as dual inline memory modules (DIMMs) of different varieties including but not limited to microDIMMs or MiniDIMMs.

Storage circuitry 2058 provides persistent storage of information such as data, applications, operating systems and so forth. In an example, the storage 2058 may be implemented via a solid-state disk drive (SSDD) and/or high-speed electrically erasable memory (commonly referred to as "flash memory"). Other devices that may be used for the storage 2058 include flash memory cards, such as SD cards, microSD cards, XD picture cards, and the like, and USB flash drives. In an example, the memory device may be or may include memory devices that use chalcogenide glass, multithreshold level NAND flash memory, NOR flash memory, single or multi-level Phase Change Memory (PCM), a resistive memory, nanowire memory, ferroelectric transistor random access memory (FeTRAM), anti-ferroelectric memory, magnetoresistive random access memory (MRAM) memory that incorporates memristor technology, phase change RAM (PRAM), resistive memory including the metal oxide base, the oxygen vacancy base and the conductive bridge Random Access Memory (CB-RAM), or spin transfer torque (STT)-MRAM, a spintronic magnetic junction memory based device, a magnetic tunneling junction (MTJ) based device, a Domain Wall (DW) and Spin Orbit Transfer (SOT) based device, a thyristor based memory device, a hard disk drive (HDD), micro HDD, of a combination thereof, and/or any other memory. The memory circuitry 2054 and/or storage circuitry 2058 may also incorporate three-dimensional (3D) cross-point (XPOINT) memories from Intel® and Micron®.

The memory circuitry 2054 and/or storage circuitry 2058 is/are configured to store computational logic 2083 in the form of software, firmware, microcode, or hardware-level instructions to implement the techniques described herein. The computational logic 2083 may be employed to store working copies and/or permanent copies of programming instructions, or data to create the programming instructions, for the operation of various components of system 2050 (e.g., drivers, libraries, application programming interfaces (APIs), etc.), an operating system of system 2050, one or more applications, and/or for carrying out the embodiments discussed herein. The computational logic 2083 may be stored or loaded into memory circuitry 2054 as instructions 2082, or data to create the instructions 2082, which are then accessed for execution by the processor circuitry 2052 to carry out the functions described herein. The processor circuitry 2052 and/or the acceleration circuitry 2064 accesses the memory circuitry 2054 and/or the storage circuitry 2058 over the interconnect (IX) 2056. The instructions 2082 direct the processor circuitry 2052 to perform a specific sequence or flow of actions, for example, as described with respect to flowchart(s) and block diagram(s) of operations and functionality depicted previously. The various elements may be implemented by assembler instructions supported by processor circuitry 2052 or high-level languages that may be compiled into instructions 2088, or data to create the instructions 2088, to be executed by the processor circuitry 2052. The permanent copy of the programming instructions may be placed into persistent storage devices of storage circuitry 2058 in the factory or in the field through, for example, a distribution medium (not shown), through a communication interface (e.g., from a distribution server (not shown)), over-the-air (OTA), or any combination thereof.

The IX 2056 couples the processor 2052 to communication circuitry 2066 for communications with other devices, such as a remote server (not shown) and the like. The communication circuitry 2066 is a hardware element, or collection of hardware elements, used to communicate over one or more networks 2063 and/or with other devices. In one example, communication circuitry 2066 is, or includes, transceiver circuitry configured to enable wireless communications using any number of frequencies and protocols such as, for example, the Institute of Electrical and Electronics Engineers (IEEE) 802.11 (and/or variants thereof), IEEE 802.23.4, Bluetooth® and/or Bluetooth® low energy (BLE), ZigBee®, LoRaWAN™ (Long Range Wide Area Network), a cellular protocol such as 3GPP LTE and/or Fifth Generation (5G)/New Radio (NR), and/or the like. Additionally or alternatively, communication circuitry 2066 is, or includes, one or more network interface controllers (NICs) to enable wired communication using, for example, an Ethernet connection, Controller Area Network (CAN), Local Interconnect Network (LIN), DeviceNet, ControlNet, Data Highway+, or PROFINET, among many others.

The IX 2056 also couples the processor 2052 to interface circuitry 2070 that is used to connect system 2050 with one or more external devices 2072. The external devices 2072 may include, for example, sensors, actuators, positioning circuitry (e.g., global navigation satellite system (GNSS)/Global Positioning System (GPS) circuitry), client devices, servers, network appliances (e.g., switches, hubs, routers, etc.), integrated photonics devices (e.g., optical neural network (ONN) integrated circuit (IC) and/or the like), and/or other like devices.

In some optional examples, various input/output (I/O) devices may be present within or connected to, the system 2050, which are referred to as input circuitry 2086 and output circuitry 2084. The input circuitry 2086 and output circuitry 2084 include one or more user interfaces designed to enable user interaction with the platform 2050 and/or peripheral component interfaces designed to enable peripheral component interaction with the platform 2050. Input circuitry 2086 may include any physical or virtual means for accepting an input including, inter alia, one or more physical or virtual buttons (e.g., a reset button), a physical keyboard, keypad, mouse, touchpad, touchscreen, microphones, scanner, headset, and/or the like. The output circuitry 2084 may be included to show information or otherwise convey information, such as sensor readings, actuator position(s), or other like information. Data and/or graphics may be displayed on one or more user interface components of the output circuitry 2084. Output circuitry 2084 may include any number and/or combinations of audio or visual display, including, inter alia, one or more simple visual outputs/indicators (e.g., binary status indicators (e.g., light emitting diodes (LEDs)) and multi-character visual outputs, or more complex outputs such as display devices or touchscreens (e.g., Liquid Crystal Displays (LCD), LED displays, quantum dot displays, projectors, etc.), with the output of characters, graphics, multimedia objects, and the like being generated or produced from the operation of the platform 2050. The output circuitry 2084 may also include speakers and/or other audio emitting devices, printer(s), and/or the like. Additionally or alternatively, sensor(s) may be used as the input circuitry 2084 (e.g., an image capture device, motion capture device, or the like) and one or more actuators may be used as the output device circuitry 2084 (e.g., an actuator to provide haptic feedback or the like). Peripheral component interfaces may include, but are not limited to, a non-volatile memory port, a USB port, an audio jack, a power supply interface, etc. In some embodiments, a display or console hardware, in the context of the present system, may be used to provide output and receive input of an edge computing system; to manage components or services of an edge computing system; identify a state of an edge computing component or service; or to conduct any other number of management or administration functions or service use cases.

The components of the system 2050 may communicate over the IX 2056. The IX 2056 may include any number of technologies, including ISA, extended ISA, I2C, SPI, point-to-point interfaces, power management bus (PMBus), PCI, PCIe, PCIx, Intel® UPI, Intel® Accelerator Link, Intel® CXL, CAPI, OpenCAPI, Intel® QPI, UPI, Intel® OPA IX, RapidIO™ system IXs, CCIX, Gen-Z Consortium IXs, a HyperTransport interconnect, NVLink provided by NVIDIA®, a Time-Trigger Protocol (TTP) system, a FlexRay system, PROFIBUS, and/or any number of other IX technologies. The IX 2056 may be a proprietary bus, for example, used in a SoC based system.

The number, capability, and/or capacity of the elements of system 2050 may vary, depending on whether computing system 2050 is used as a stationary computing device (e.g., a server computer in a data center, a workstation, a desktop computer, etc.) or a mobile computing device (e.g., a smartphone, tablet computing device, laptop computer, game console, IoT device, etc.). In various implementations, the computing device system 2050 may comprise one or more components of a data center, a desktop computer, a workstation, a laptop, a smartphone, a tablet, a digital camera, a smart appliance, a smart home hub, a network appliance, and/or any other device/system that processes data.

The techniques described herein can be performed partially or wholly by software or other instructions provided in a machine-readable storage medium (e.g., memory). The software is stored as processor-executable instructions (e.g., instructions to implement any other processes discussed herein). Instructions associated with the flowchart (and/or various embodiments) and executed to implement embodiments of the disclosed subject matter may be implemented as part of an operating system or a specific application, component, program, object, module, routine, or other sequence of instructions or organization of sequences of instructions.

The storage medium can be a tangible, non-transitory machine readable medium such as read only memory (ROM), random access memory (RAM), flash memory devices, floppy and other removable disks, magnetic storage media, optical storage media (e.g., Compact Disk Read-Only Memory (CD ROMS), Digital Versatile Disks (DVDs)), among others.

The storage medium may be included, e.g., in a communication device, a computing device, a network device, a personal digital assistant, a manufacturing tool, a mobile communication device, a cellular phone, a notebook computer, a tablet, a game console, a set top box, an embedded system, a TV (television), or a personal desktop computer.

Some non-limiting examples of various embodiments are presented below.

Example 1 includes an apparatus, comprising: an array of memory cells in a plurality of rows and a plurality of columns; and bit lines and select lines associated with the array, wherein a memory cell in the array comprises a primary element coupled to a respective bit line and a respective select line, and a secondary element coupled to the respective bit line and the respective select line, in parallel with the primary element.

Example 2 includes the apparatus of Example 1, further comprising: a first access transistor in series with the primary element; a second access transistor in series with the secondary element; a first control line coupled to a control gate of the first access transistor; and a second control line coupled to a control gate of the second access transistor.

Example 3 includes the apparatus of Example 1 or 2, wherein: the memory cell is in a column of the plurality of columns; respective memory cells of the column comprise respective primary and secondary elements coupled in parallel; a first control line is coupled to control gates of access transistors of the respective primary elements; and a second control line is coupled to control gates of access transistors of the respective secondary elements.

Example 4 includes the apparatus of any one of Examples 1-3, wherein the primary and secondary elements are phase-change elements.

Example 5 includes the apparatus of any one of Examples 1-4, wherein the primary and secondary elements are floating gate metal-oxide-semiconductor field-effect transistors (MOSFETs).

Example 6 includes the apparatus of any one of Examples 1-5, wherein the secondary element is smaller in size than the primary element.

Example 7 includes the apparatus of any one of Examples 1-6, wherein the secondary element has a smaller conductivity than the primary elementwhen the primary and secondary elements are biased by the respective bit line and the respective select line.

Example 8 includes the apparatus of any one of Examples 1-7, wherein the array of memory cells, the bit lines and the select lines are is provided in at least one of an integrated circuit, a System on Chip, a System in Package or a computing device.

Example 9 includes a system, comprising: an array of memory cells in plurality of rows and a plurality of columns, wherein respective memory cells of a column of the plurality of columns comprise respective primary and secondary elements coupled in parallel; a memory capable of storing instructions; and a processor capable of executing the instructions to: program the primary elements and disable the secondary elements; measure a current in the column through the primary elements; and program the secondary elements based on the measuring and disable the primary elements.

Example 10 includes the system of Example 9, wherein the processor is capable of executing the instructions to reset the primary and secondary elements before the programming of the primary elements.

Example 11 includes the system of Example 9 or 10, wherein the programming of the primary and secondary elements comprises one-shot programming.

Example 12 includes the system of any one of Examples 9-11, wherein the processor is capable of executing the instructions to determine at least one of an amplitude or a duration of a program pulse to for the programming of the secondary elements.

Example 13 includes the system of any one of Examples 9-12, wherein the measuring comprises determining a delta by which a conductivity of the primary elements is below a target value.

Example 14 includes the system of Example 13, wherein the processor is capable of executing the instructions to determine at least one of an amplitude or a duration of a program pulse based on the delta for the programming of the secondary elements.

Example 15 includes the system of any one of Examples 9-14, further comprising: a first control line coupled to control gates of access transistors of the respective primary elements of the column of memory cells; and a second control line coupled to control gates of access transistors of the respective secondary elements of the column of memory cells.

Example 16 includes the system of any one of Examples 9-15, wherein the primary and secondary elements are resistive-switching elements.

Example 17 includes an apparatus, comprising: a row driver circuit capable of applying an alternating-current (AC) signal comprising positive and negative voltages to a bit line of a memory array, wherein the bit line is coupled to one or more memory cells in the memory array; and a column circuit to sense a current in one or more select lines coupled to the one or more memory cells in the memory array, to perform a compute-in-memory operation in the memory array.

Example 18 includes the apparatus of Example 17, wherein: the AC signal is a first AC signal; the bit line is a first bit line; the row driver circuit is capable of applying a second AC signal to a second bit line of the memory array; the first AC signal has a first frequency; and the second AC signal has a second frequency, different than the first frequency.

Example 19 includes the apparatus of Example 18, wherein the column circuit comprises a frequency-selective sense circuit.

Example 20 includes the apparatus of any one of Examples 17-19, wherein: the AC signal is a first AC signal; the bit line is a first bit line; the row driver circuit is capable of applying a second AC signal to a second bit line of the memory array; and the second AC signal has a different amplitude than the first AC signal.

Example 21 includes a method, comprising: programming primary elements while secondary elements are disabled in an array of memory cells in plurality of rows and a plurality of columns, wherein respective memory cells of a column of the plurality of columns comprise respective primary and secondary elements coupled in parallel; measuring a current in the column through the primary elements; and programming the secondary elements based on the measuring while the primary elements are disabled.

Example 22 includes the method of Example 21, wherein the programming of the primary and secondary elements comprises one-shot programming.

Example 23 includes the method of Example 21 or 22, further comprising determining at least one of an amplitude or a duration of a program pulse to for the programming of the secondary elements.

Example 24 includes the method of any one of Examples 21-23, wherein the measuring comprises determining a delta by which a conductivity of the primary elements is below a target value.

Example 25 includes the method of Example 24, further comprising determining at least one of an amplitude or a duration of a program pulse based on the delta for the programming of the secondary elements.

Example 26 includes an apparatus, comprising means to perform the method of any one of Examples 21-25.

Example 27 includes a machine-readable storage including machine-readable instructions which, when executed, cause a computer to implement the method of any one of Examples 21-25.

Example 28 includes a computer program comprising instructions which, when executed by a computer, cause the computer to carry out the method of any one of Examples 21-25.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order than the described embodiment. Various additional operations may be performed and/or described operations may be omitted in additional embodiments.

The terms "substantially," "close," "approximately," "near," and "about," generally refer to being within +/- 10% of a target value. Unless otherwise specified the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

For the purposes of the present disclosure, the phrases "A and/or B" and "A or B" mean (A), (B), or (A and B). For the purposes of the present disclosure, the phrase "A, B, and/or C" means (A), (B), (C), (A and B), (A and C), (B and C), or (A, B, and C).

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

As used herein, the term "circuitry" may refer to, be part of, or include an Application Specific Integrated Circuit (ASIC), an electronic circuit, a processor (shared, dedicated, or group), a combinational logic circuit, and/or other suitable hardware components that provide the described functionality. As used herein, "computer-implemented method" may refer to any method executed by one or more processors, a computer system having one or more processors, a mobile device such as a smartphone (which may include one or more processors), a tablet, a laptop computer, a set-top box, a gaming console, and so forth.

The terms "coupled," "communicatively coupled," along with derivatives thereof are used herein. The term "coupled" may mean two or more elements are in direct physical or electrical contact with one another, may mean that two or more elements indirectly contact each other but still cooperate or interact with each other, and/or may mean that one or more other elements are coupled or connected between the elements that are said to be coupled with each other. The term "directly coupled" may mean that two or more elements are in direct contact with one another. The term "communicatively coupled" may mean that two or more elements may be in contact with one another by a means of communication including through a wire or other interconnect connection, through a wireless communication channel or link, and/or the like.

Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included. If the specification or claim refers to "a" or "an" element, that does not mean there is only one of the elements. If the specification or claims refer to "an additional" element, that does not preclude there being more than one of the additional elements.

Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

While the disclosure has been described in conjunction with specific embodiments thereof, many alternatives, modifications and variations of such embodiments will be apparent to those of ordinary skill in the art in light of the foregoing description. The embodiments of the disclosure are intended to embrace all such alternatives, modifications, and variations as to fall within the broad scope of the appended claims.

In addition, well-known power/ground connections to integrated circuit (IC) chips and other components may or may not be shown within the presented figures, for simplicity of illustration and discussion, and so as not to obscure the disclosure. Further, arrangements may be shown in block diagram form in order to avoid obscuring the disclosure, and also in view of the fact that specifics with respect to implementation of such block diagram arrangements are highly dependent upon the platform within which the present disclosure is to be implemented (i.e., such specifics should be well within purview of one skilled in the art). Where specific details (e.g., circuits) are set forth in order to describe example embodiments of the disclosure, it should be apparent to one skilled in the art that the disclosure can be practiced without, or with variation of, these specific details. The description is thus to be regarded as illustrative instead of limiting.

An abstract is provided that will allow the reader to ascertain the nature and gist of the technical disclosure. The abstract is submitted with the understanding that it will not be used to limit the scope or meaning of the claims. The following claims are hereby incorporated into the detailed description, with each claim standing on its own as a separate embodiment.

**Claims**

1. An apparatus, comprising:

   an array of memory cells in a plurality of rows and a plurality of columns; and
   bit lines and select lines associated with the array, wherein a memory cell in the array comprises a primary element coupled to a respective bit line and a respective select line, and a secondary element coupled to the respective bit line and the respective select line, in parallel with the primary element.

2. The apparatus of claim 1, further comprising:

   a first access transistor in series with the primary element;
   a second access transistor in series with the secondary element;
   a first control line coupled to a control gate of the first access transistor; and
   a second control line coupled to a control gate of the second access transistor.

3. The apparatus of claim 1, wherein:

   the memory cell is in a column of the plurality of columns;
   respective memory cells of the column comprise respective primary and secondary elements coupled in parallel;
   a first control line is coupled to control gates of access transistors of the respective primary elements; and
   a second control line is coupled to control gates of access transistors of the respective secondary elements.

4. The apparatus of claim 1, wherein the primary and secondary elements are phase-change elements.

5. The apparatus of claim 1, wherein the primary and secondary elements are floating gate metal-oxide-semiconductor field-effect transistors (MOSFETs).

6. The apparatus of claim 1, wherein the secondary element is smaller in size than the primary element.

7. The apparatus of claim 1, wherein the secondary element has a smaller conductivity than the primary element when the primary and secondary elements are biased by the respective bit line and the respective select line.

8. The apparatus of claim 1, wherein the array of memory cells, the bit lines and the select lines are is provided in at least one of an integrated circuit, a System on Chip, a System in Package or a computing device.

9. The apparatus of any one of claims 1-8, further comprising:

a memory capable of storing instructions; and
a processor capable of executing the instructions to:

program the primary elements and disable the secondary elements;
measure a current in the column through the primary elements; and
program the secondary elements based on the measuring and disable the primary elements.

10. The apparatus of claim 9, wherein the processor is capable of executing the instructions to reset the primary and secondary elements before the programming of the primary elements.

11. The apparatus of claim 9 or 10, wherein the programming of the primary and secondary elements comprises one-shot programming.

12. The apparatus of any one of claims 9-11, wherein the processor is capable of executing the instructions to determine at least one of an amplitude or a duration of a program pulse for the programming of the secondary elements.

13. The apparatus of any one of claims 9-12, wherein the measuring comprises determining a delta by which a conductivity of the primary elements is below a target value.

14. The apparatus of claim 13, wherein the processor is capable of executing the instructions to determine at least one of an amplitude or a duration of a program pulse based on the delta for the programming of the secondary elements.

15. The apparatus of any one of claims 1-14, wherein the primary and secondary elements are resistive-switching elements.

$$\begin{bmatrix} W_{11} & \cdots & W_{1N} \\ & \cdots & \\ & \cdots & \\ & \cdots & \\ & \cdots & \\ W_{M1} & \cdots & W_{MN} \end{bmatrix} \begin{bmatrix} IN_1 \\ \cdot \\ \cdot \\ \cdot \\ IN_N \end{bmatrix} = \begin{bmatrix} OUT_1 \\ \cdot \\ \cdot \\ \cdot \\ OUT_M \end{bmatrix}$$

Fig. 1

Fig. 2

Fig. 3

Fig. 4

Fig. 5

Fig. 6

Fig. 7

Fig. 8

Fig. 9

Reset the primary (large) and secondary
(small) elements in a column
1000

↓

Program the primary (large) elements in the
column with a first program pulse
1001

↓

Measure the current in the column through
the primary elements
1002

↓

Determine a delta between the sensed
current and a target current
1003

↓

Determine an amplitude and/or duration of a
second program pulse based on delta
1004

↓

Program the secondary (small) elements in
the column with the second program pulse
1005

↓

Next column?
1006

T

F

↓

End
1007

Fig. 10

Fig. 11

Fig. 12

Fig. 13

Fig. 14A

Fig. 14B

Fig. 15

1600

OUTj

fi

1601

Local oscillator
1602

fLO(fi)

fINT=|fi-fLO(fi)|

IF filter/amplifier
1603

Demodulator
1604

Fig. 16

Fig. 17A

Fig. 17B

Fig. 18A

Fig. 18B

Fig. 19A

Fig. 19B

Fig. 19C

Computing System 2050

Processor Circuitry
2052

Instructions 2088

Memory Circuitry 2054

Instructions 2082

Storage Circuitry 2058

Logic 2083

Voltage regulator 2000

Acceleration circuitry
2064

Communication Circuitry
2066

Input circuitry 2086

Interface Circuitry 2070

Output Circuitry 2084

Network
2063

External Devices
2072

2056

Fig. 20

Europäisches
Patentamt

European
Patent Office

Office européen
des brevets

# EUROPEAN SEARCH REPORT

**Application Number**

**EP 25 19 7071**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/236445 A1 (DAS SHIDHARTHA [GB] ET AL) 1 August 2019 (2019-08-01) * paragraph [0107] - paragraph [0117]; figure 8 * | 1-15 | INV. G11C11/54 G11C13/00 ADD. G11C7/10 |
| A | US 2023/082961 A1 (LI JUNTAO [US] ET AL) 16 March 2023 (2023-03-16) * paragraph [0068] - paragraph [0070]; figures 21-23 * | 1-15 | |
| A | US 2008/123393 A1 (KINOSHITA KENTARO [JP]) 29 May 2008 (2008-05-29) * paragraph [0191] - paragraph [0196]; figure 12 * | 1-15 | |

**TECHNICAL FIELDS SEARCHED (IPC)**

G11C

The present search report has been drawn up for all claims

| Place of search | Date of completion of the search | Examiner |
|---|---|---|
| The Hague | 22 January 2026 | Lecoutre, Renaud |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 19 7071

This annex lists the patent family members relating to the patent documents cited in the above-mentioned European search report.
The members are as contained in the European Patent Office EDP file on
The European Patent Office is in no way liable for these particulars which are merely given for the purpose of information.

22-01-2026

| Patent document cited in search report | | Publication date | Patent family member(s) | | Publication date |
|---|---|---|---|---|---|
| US 2019236445 | A1 | 01-08-2019 | CN | 109416760 A | 01-03-2019 |
| | | | GB | 2552014 A | 10-01-2018 |
| | | | KR | 20190022622 A | 06-03-2019 |
| | | | US | 2019236445 A1 | 01-08-2019 |
| | | | WO | 2018007783 A1 | 11-01-2018 |
| US 2023082961 | A1 | 16-03-2023 | CN | 116472790 A | 21-07-2023 |
| | | | US | 2023082961 A1 | 16-03-2023 |
| US 2008123393 | A1 | 29-05-2008 | EP | 1895540 A1 | 05-03-2008 |
| | | | JP | WO2006137111 A1 | 08-01-2009 |
| | | | US | 2008123393 A1 | 29-05-2008 |
| | | | WO | 2006137111 A1 | 28-12-2006 |

EPO FORM P0459

For more details about this annex : see Official Journal of the European Patent Office, No. 12/82